(19) Europäisches Patentamt
European Patent Office
Office européen des brevets

(11) **EP 3 028 054 B1**

(12) **FASCICULE DE BREVET EUROPEEN**

(45) Date de publication et mention
de la délivrance du brevet:
**21.06.2023 Bulletin 2023/25**

(21) Numéro de dépôt: **14750572.1**

(22) Date de dépôt: **16.07.2014**

(51) Classification Internationale des Brevets (IPC):
**B60L 58/14** (2019.01)   **B60L 58/15** (2019.01)
**B60L 58/24** (2019.01)   **G01R 31/367** (2019.01)
**G01R 31/392** (2019.01)   **H01M 10/48** (2006.01)
**H01M 10/44** (2006.01)

(52) Classification Coopérative des Brevets (CPC):
**G01R 31/392; B60L 58/14; B60L 58/15;**
**B60L 58/24; G01R 31/367;** G01R 31/3842;
G01R 31/389; H01M 10/44; H01M 10/48;
Y02E 60/10; Y02T 10/70

(86) Numéro de dépôt international:
**PCT/FR2014/051826**

(87) Numéro de publication internationale:
**WO 2015/015083 (05.02.2015 Gazette 2015/05)**

(54) **ESTIMATION DE L'ÉTAT DE VIEILLISSEMENT D'UNE BATTERIE ÉLECTRIQUE**

EINSCHÄTZUNG DES ZERSETZUNGSZUSTANDS EINER STROMBATTERIE

ESTIMATION OF THE STATE OF DETERIORATION OF AN ELECTRIC BATTERY

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **29.07.2013 FR 1357472**

(43) Date de publication de la demande:
**08.06.2016 Bulletin 2016/23**

(73) Titulaire: **Renault s.a.s**
**92100 Boulogne Billancourt (FR)**

(72) Inventeurs:
• **SAINT-MARCOUX, Antoine**
**F-91120 Palaiseau (FR)**
• **ORIGUCHI, Masato**
**F-78120 Rambouillet (FR)**
• **DELOBEL, Bruno**
**F-75015 Paris (FR)**
• **CREACH, Thomas**
**F-78000 Versailles (FR)**
• **SOULIER, Juan-Pablo**
**F-75011 Paris (FR)**

(74) Mandataire: **Renault Group**
**Renault s.a.s.**
**API : TCR GRA 2 36**
**1, Avenue du Golf**
**78084 Guyancourt Cedex (FR)**

(56) Documents cités:
**WO-A1-2012/091076    WO-A1-2012/148019**
**FR-A1- 2 971 855**

**Description**

L'invention a pour objet la gestion de la charge d'une batterie d'accumulateurs électriques, en particulier la gestion de la charge d'une batterie pour véhicule automobile électrique et/ou hybride. De telles batteries peuvent être par exemple de type Lithium-ion. Elles comportent généralement une pluralité d'accumulateurs électriques, également appelés cellules. Chaque cellule comprend un système électrochimique apte à être rechargé jusqu'à une tension maximale à vide, et délivrer ensuite un courant électrique sous une tension qui est d'abord légèrement inférieure à la tension maximale à vide, puis qui diminue, à intensité de courant constante, jusqu'à la prochaine étape de rechargement de la batterie. Les batteries sont généralement contrôlées par un système de contrôle électronique de batterie (BMS - « Battery Management System ») qui pilote par exemple les phases de recharge de la batterie pour amener la batterie à la tension souhaitée en fin de recharge sans provoquer un échauffement excessif de la batterie et en évitant qu'une des cellules arrive à un niveau de charge sensiblement plus élevé, ou sensiblement moins élevé, que les autres cellules de la batterie.

Le système BMS peut être configuré pour calculer une variable sans dimensions "SOC" (State of Charge) permettant de quantifier par une variable comprise entre zéro et 1 le niveau de charge de la batterie, suivant des méthodes connues par ailleurs, faisant par exemple intervenir une intégrale des valeurs d'intensité de courant ayant traversé la batterie, une variation de niveau de tension de la batterie, une tension à vide de la batterie mesurée à un instant où le courant traversant la batterie était nul.

Un système BMS assure une protection de la batterie en l'empêchant de fonctionner en dehors de sa plage de fonctionnement typique, et assure une protection notamment contre la surintensité, la surtension (lors de la charge), la sous-tension (lors de la décharge) ou encore, ce qui est particulièrement important pour les batteries Li-ion, contre la surchauffe et la sous-température.

Le système BMS permet notamment de gérer la charge de la batterie en imposant au moment des phases de rechargement le niveau maximal de puissance autorisée en charge. Il permet d'afficher des valeurs caractéristiques de l'état de la batterie telles que le SOC. Le système BMS peut également être configuré pour estimer au cours du roulage du véhicule une valeur SOHE (State of Health Energy), qui est un coefficient permettant de quantifier le niveau d'énergie disponible dans la batterie une fois celle-ci chargée à son plein potentiel, en tenant compte de la dégradation des performances de la batterie au cours de son cycle de vie. Une valeur SOHE peut par exemple être calculée comme le rapport entre :

- l'énergie qu'on peut puiser sur la batterie à partir de son état pleinement chargé, à son état d'usure actuel, à une température de référence (ex : 25°C), à un niveau de courant constant de référence (par exemple 33A pour une cellule de 33Ah), jusqu'à ce que la tension aux bornes de la batterie descende à un seuil bas de tension (ex : 2.5V).
- l'énergie qu'on peut puiser sur la batterie à partir de son état pleinement chargé, à l'état neuf, à la même température de référence, au même niveau de courant constant de référence, jusqu'à ce que la tension aux bornes de la batterie descende au seuil bas de tension.

Le seuil bas de tension peut correspondre à la tension minimale aux bornes de la batterie en deçà de laquelle on interdit de puiser sur la batterie pour ne pas la dégrader (tension dite "de coupure").

La valeur SOHE peut être calculée par diverses méthodes mentionnées plus loin, et permet d'estimer l'énergie disponible dans la batterie en fin de charge et le kilométrage que le conducteur peut donc espérer parcourir.

Pour améliorer la précision de l'estimation d'autonomie du véhicule, on a donc intérêt à estimer le SOHE de la manière la plus précise possible; Or, les sources d'erreur de calcul sont diverses, et leur amplitude varie avec l'avancée en âge de la batterie et les cyclages qu'elle subit. En outre, afin de ne pas inquiéter le conducteur du véhicule par des fluctuations de l'autonomie estimée qui pourraient paraître erratiques d'une recharge à la suivante, il est préférable que l'évolution de la valeur estimée de SOHE soit régulière d'une recharge à la suivante.

En outre, à partir d'une estimation fiable du SOHE de la batterie, on peut envisager d'optimiser les cycles de charge -décharge de la batterie de manière à augmenter la durée de vie de la batterie par rapport à des cycles de charge-décharge qui seraient toujours effectués entre les mêmes limites de tensions à vide de la batterie.

Il existe de nombreux modèles empiriques de vieillissement de batteries. Par exemple, le document «R. Spotnitz, "Simulation of capacity fade in lithium ion batteries", Journal of Power Sources 113 (2003) 72-80», permet de prévoir un vieillissement théorique de la batterie, pour un profil d'utilisation client donné. Le modèle proposé est un modèle en boucle ouverte. Autrement dit, en cas de dégradation de la batterie non prévue par le modèle (dégradation anormale ou modèle mal calibré), l'estimation du SOHE pourra être erronée : le SOHE suit l'évolution de la batterie théorique ayant servi à calibrer le modèle, mais n'est pas réajusté en fonction de la dégradation de la batterie réelle.

Le document "METHOD AND APPARATUS OF ESTIMATING STATE OF HEALTH OF BATTERY" (US2007/0001679 A1) divulgue qu'il existe un lien entre la résistance interne d'une cellule de batterie et son état de vieillissement (SOH ou "State Of Health"). Elle propose de comparer la résistance interne estimée d'une cellule à des valeurs de résistance de référence cartographiées. Un inconvénient de cette méthode est que l'estimation du SOHE dépend en outre du profil d'utilisation effectif (courant, température) de la batterie.

Le brevet US 6,653,817 (General Motors) divulgue également une méthode d'estimation de l'état de vieillissement de la batterie à partir de la caractérisation de sa résistance interne. La méthode exposée dans le document nécessite une architecture de système avec des composants électroniques spécifiques de haute puissance. De plus, la méthode utilise un intermédiaire de calcul, le SOHP ("State of Health Power"), et une mauvaise caractérisation du lien SOHP-SOHE peut aboutir à une erreur d'estimation du SOHE importante.

Il existe enfin des méthodes d'estimation de l'état de vieillissement d'une batterie dite par «comptage coulombique», comme par exemple celle décrite dans « Enhanced coulomb counting method for estimating state-of-charge and state-of-health of lithium-ion batteries » (Applied Energy, Volume 86, Issue 9, sept 2009, pages 1506-1511). Un inconvénient de cette méthode est qu'elle manque de précision dès lors que l'on ne décharge que partiellement la batterie entre deux recharges, par exemple lorsque le profil de routes parcourues ou la fréquence des recharges sur secteur amènent le SOC à varier entre 100% et 50% sans jamais descendre en dessous.

Le document WO 20121091076 divulgue une méthode de détection d'un niveau de dégradation d'une batterie électrique dont la précision est variable.

L'invention a pour but de proposer une estimation de l'état de vieillissement d'une batterie équipant un véhicule électrique ou hybride qui soit précise sur toute la durée de vie de la batterie et ne soit pas tributaire des habitudes de conduite du conducteur. L'invention vise également à optimiser la gestion des phases de recharge de la batterie en fonction de l'état de vieillissement calculé, de manière à prolonger la durée de vie de la batterie.

A cette fin, l'invention propose un procédé de gestion d'un accumulateur électrochimique ou d'une batterie d'accumulateurs, dans lequel on détermine une valeur estimée d'un état de vieillissement de l'accumulateur, à partir de l'historique des valeurs de tension aux bornes de l'accumulateur, de l'historique de l'intensité de courant traversant l'accumulateur, et de l'historique de température aux bornes de l'accumulateur. La valeur estimée est une valeur barycentrique d'état de vieillissement calculée comme un barycentre d'au moins deux valeurs indicatives de l'état de vieillissement de l'accumulateur, soit une première valeur indicative de l'état de vieillissement de l'accumulateur calculée par une première méthode et une seconde valeur indicative de l'état de vieillissement de l'accumulateur calculée par une seconde méthode différente de la première méthode. A partir d'un état initial de mise en service de l'accumulateur, on fait varier au moins une fois les coefficients barycentriques permettant de calculer la prochaine valeur barycentrique d'état de vieillissement de l'accumulateur, quand une précédente valeur du SOHE de l'accumulateur calculée selon la première méthode a franchi un premier seuil.

Avantageusement, la première valeur indicative est calculée à partir d'une première somme de premiers coefficients fonctions de températures et états de charges caractérisant des états successifs de l'accumulateur, premiers coefficients multipliés chacun par le temps passé dans chaque état, et d'une seconde somme de seconds coefficients fonctions de températures et états de charges caractérisant des états successifs de l'accumulateur, seconds coefficients multipliés chacun par l'énergie déchargée par la batterie dans cet état. Avantageusement, la première valeur indicative est calculée en prenant en compte la somme d'une première puissance de la première somme et d'une seconde puissance de la seconde somme. La première valeur indicative peut par exemple être calculée comme le complément à 1 de la somme d'une première puissance de la première somme et d'une seconde puissance de la seconde somme.

Selon un mode de réalisation préférentiel, la seconde méthode de calcul est une méthode de calcul faisant apparaître des termes de calcul intermédiaires assimilables à une résistance interne de l'accumulateur et/ou assimilables à un calcul de capacité de charge totale de la batterie.

De manière plus générale, la première méthode de calcul peut être une méthode de calcul en boucle ouverte, et la seconde méthode de calcul peut être une méthode de calcul en boucle fermée. On considère ici qu'une méthode de calcul est une méthode en boucle ouverte si elle procède en sommant des valeurs calculées en fonction de valeurs enregistrées successivement sur la batterie au cours du temps sans se préoccuper de l'amplitude (écarts en SOC ou écarts en tension) du cyclage en cours. Une méthode en boucle ouverte ne permet pas de détecter si la batterie se dégrade prématurément de manière anormalement rapide. On considère ici qu'une méthode de calcul est une méthode en boucle fermée si elle comporte des valeurs intermédiaires de calcul représentant des valeurs physiques connues pour refléter l'évolution réelle de l'état de vieillissement de la batterie, telles que la résistance interne de la batterie, la résistance interne apparente de la batterie, ou la capacité de charge totale de la batterie. Une méthode peut être en particulier considérée en boucle fermée si elle prévoit de calculer des valeurs intermédiaires à partir de valeurs acquises lors d'une amplitude de cyclage de la batterie supérieure à un seuil de cyclage, et/ou si la méthode prévoit de calculer des valeurs intermédiaires par un filtre numérique sensible aux écarts de comportement de la batterie par rapport à un jeu d'équation de comportement théorique (par exemple les calculs de SOC et de capacité totale de la batterie par des méthodes de type filtre de Kalman). Les méthodes de calcul en boucle fermée permettent de détecter un écart de comportement entre deux batteries, de même comportement théorique annoncé, mais de performances réelles différentes, même si on impose à ces batteries les mêmes cyclages au cours du temps. C'est une approche adaptative.

Selon une variante de réalisation, on peut calculer la valeur barycentrique comme un barycentre de plus de deux valeurs indicatives de l'état de vieillissement de la batterie, par exemple un barycentre de trois valeurs indicatives de l'état de vieillissement de la batterie calculées par des méthodes différentes. La première valeur indicative peut être calculée par une méthode couramment désignée par "modèle empirique", faisant intervenir des sommes de termes fonction de températures et états de charges caractérisant des états successifs de l'accumulateur. La seconde valeur indicative de l'état de vieillissement et/ou la troisième valeur indicative de l'état de vieillissement peuvent être calculées respectivement par une méthode dite de comptage coulombique, faisant intervenir un calcul de l'évolution de la capacité totale de charge de l'accumulateur au cours du temps, et par une méthode dite d'impédance ou de résistance interne, faisant intervenir un calcul de l'évolution d'une impédance ou d'une résistance interne de l'accumulateur au cours du temps.

De préférence, le coefficient de pondération associé à la valeur calculée par la première méthode est strictement supérieur à 0,5 lors de la mise en service de la batterie et diminue ensuite, et le coefficient de pondération associé à la valeur calculée par la seconde méthode est strictement inférieur à 0,5 et augmente ensuite au cours du temps.

Le coefficient barycentrique associé à la première valeur indicative de l'état de vieillissement peut rester constant jusqu'à ce que la valeur barycentrique franchisse un premier seuil, puis varier de manière sensiblement affine en fonction de la valeur barycentrique jusqu'à ce que la valeur barycentrique franchisse un second seuil.

Avantageusement, la valeur barycentrique peut être plus proche de, voire égale à, la première valeur indicative de l'état de vieillissement jusqu'au franchissement d'un premier seuil par la valeur barycentrique. Puis la valeur barycentrique peut devenir progressivement plus proche d'une seconde valeur indicative de l'état de vieillissement, jusqu'à égaler cette seconde valeur indicative en même temps qu'elle atteint un second seuil. Eventuellement, quand la valeur barycentrique franchit un troisième seuil, elle peut, par le jeu des coefficients barycentriques, commencer à se rapprocher d'une troisième valeur indicative de l'état de vieillissement jusqu'à l'atteindre au moment où elle atteint un quatrième seuil.

Selon un mode de réalisation préféré, la seconde valeur indicative de l'état de vieillissement est calculée par une méthode de type comptage coulombique, et la troisième valeur indicative de l'état de vieillissement est calculée par une méthode faisant intervenir un calcul de l'évolution d'une impédance ou d'une résistance interne de l'accumulateur.

Selon une application de l'invention à un accumulateur embarqué sur un véhicule, au cours des étapes de rechargement de l'accumulateur, on impose une tension de fin de charge qui est calculée en fonction de la valeur barycentrique, cette tension de fin de charge étant augmentée progressivement au cours de l'utilisation de l'accumulateur sur un véhicule.

Selon un mode de réalisation avantageux, entre la mise en service de l'accumulateur et une cinquième valeur seuil de la valeur barycentrique, la tension de fin de charge est imposée pour varier de manière affine par rapport à la valeur barycentrique, puis est maintenue sensiblement constante pour la suite de l'utilisation de l'accumulateur sur le véhicule.

Selon une variante de réalisation, la tension de fin de charge est une fonction croissante ou une fonction décroissante de la valeur barycentrique, cette tension de fin de charge variant plus rapidement par rapport à la valeur barycentrique au moment de la mise en service de l'accumulateur, qu'en fin de vie de l'accumulateur. En fin de vie de l'accumulateur, la courbe de tension de fin de charge peut présenter un plateau ou converger vers un plateau.

Selon un autre aspect, l'invention propose un système d'alimentation électrique comprenant au moins un accumulateur électrochimique, un capteur de température associé à l'accumulateur, un capteur de tension et un capteur d'intensité de courant permettant d'estimer la tension aux bornes de l'accumulateur et l'intensité de courant traversant l'accumulateur, un calculateur configuré pour estimer, en utilisant notamment les valeurs de tension et d'intensité, un niveau de charge de l'accumulateur au cours du temps. Le système comprend une unité de commande électronique configurée pour calculer une valeur barycentrique d'un état de vieillissement de l'accumulateur, comme un barycentre d'au moins une première et une seconde valeurs caractérisant un état de vieillissement de l'accumulateur et calculées par deux méthodes différentes. Les coefficients barycentriques utilisés pour calculer la valeur barycentrique à un instant donné dépendent de la valeur prise par la première valeur caractérisant l'état de vieillissement lors de l'évaluation de celle-ci à un instant précédent.

Le système d'alimentation électrique comprend une unité de gestion de l'accumulateur configurée pour augmenter au cours du cycle de vie de l'accumulateur, la tension de fin de charge définissant la tension maximale à vide à laquelle on autorise un système de recharge à amener l'accumulateur. La tension de fin de charge est imposée en fonction de la valeur barycentrique calculée.

D'autres buts, caractéristiques et avantages de l'invention apparaîtront à la lecture de la description suivante donnée uniquement à titre d'exemple non limitatif, et faite en référence aux dessins annexés, sur lesquels :

- la figure 1 est une vue schématique d'un véhicule automobile équipé d'une batterie et d'un système de gestion de batterie selon l'invention,
- la figure 2 est un algorithme de calcul simplifié d'un état de vieillissement d'une batterie par le système de gestion de batterie selon l'invention.

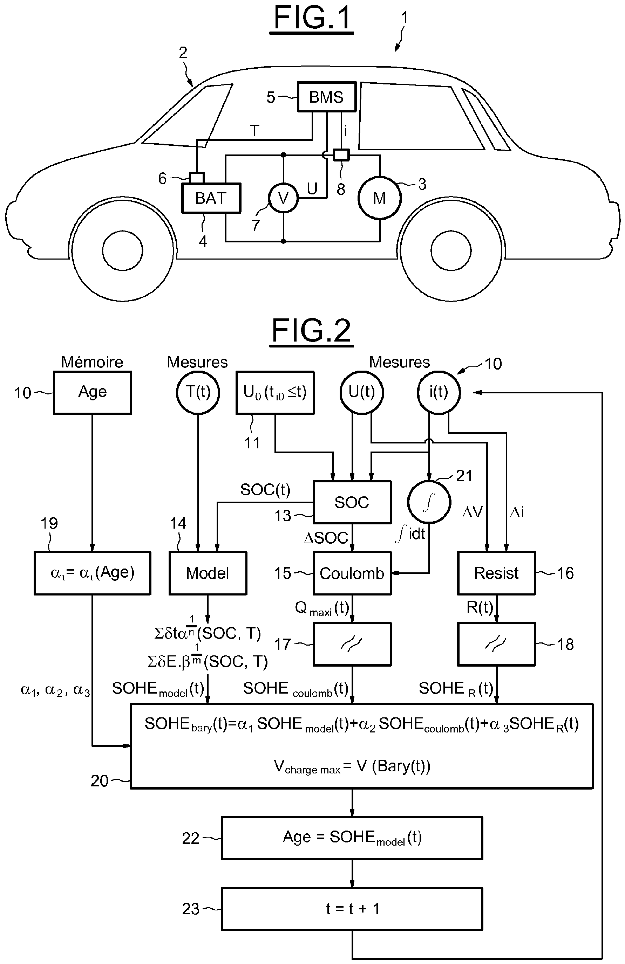

Tel qu'illustré sur la figure 1, un véhicule automobile 1, par exemple un véhicule automobile de type électrique ou de type hybride, est équipé d'un moteur 3 apte à entraîner les roues du véhicule et d'un système d'alimentation électrique 2 apte à alimenter le moteur 3. Le système d'alimentation électrique 2 comprend notamment une batterie d'accumulateur électrique 4, une unité de commande électronique 5 configurée pour gérer la batterie 4 et désignée par le sigle BMS comme « Battery Management System ». La batterie 4 est équipée d'un capteur de température 6 apte à mesurer une température T caractéristique de la batterie qui est transmise au BMS 5. La batterie est également équipée d'un voltmètre 7 permettant de connaître la tension U aux bornes de la batterie 4 et transmettant cette valeur U au BMS 5. Un ampèremètre 8 est enfin connecté à la batterie 4 de manière à mesurer l'intensité de courant traversant la batterie 4. La valeur i correspondant à l'intensité de courant est également transmise au BMS 5.

Le système BMS permet notamment de surveiller la tension aux bornes de la batterie et l'intensité de courant traversant la batterie, permet d'estimer un état de charge de la batterie, et en fonction notamment de l'état de charge de la batterie, de paramètres tels que la température de la batterie ou des températures de cellules électrochimiques constituant la batterie, permet par exemple d'interdire l'application d'une tension supérieure à un seuil aux bornes de la batterie et/ou la circulation d'un courant supérieur à un seuil au travers de la batterie.

Le système BMS peut également interdire de puiser de l'énergie sur la batterie lorsque l'état de charge de celle-ci descend en-dessous d'un certain seuil, et imposer la tension appliquée aux bornes de la batterie pendant la recharge de celle-ci sur secteur par exemple, de manière à amener la batterie à une tension de fin de charge.

Le système BMS 5 peut être configuré pour calculer des valeurs telles qu'un niveau de charge (SOC : State Of Charge) de la batterie 4, une valeur SOHE caractérisant un état de vieillissement de la batterie, une capacité maximale de charge $Q_{max}$ de la batterie, correspondant sensiblement à l'énergie maximale que la batterie peut emmagasiner à son niveau de mesure actuel. Le BMS peut utiliser ces valeurs pour ajuster les bornes de fonctionnement dans lesquelles il autorise le fonctionnement de la batterie (tension minimale aux bornes de la batterie avant d'interdire de puiser de l'énergie sur la batterie, tension maximale aux bornes de la batterie en fin de rechargement de la batterie, puissance maximale instantanée que l'on autorise à puiser sur la batterie...).

La figure 2 illustre en particulier un processus de calcul mis en oeuvre par le BMS 5 de la figure 1 pour estimer une valeur $SOHE_{bary}$ représentative de l'état de vieillissement de la batterie, en tenant compte de l'usure de la batterie 4. Pour les raisons décrites plus bas, le calcul de cette valeur $SOHE_{bary}$ est fait en effectuant une moyenne pondérée ou une moyenne barycentrique de trois estimations d'état de vieillissement $SOHE_{model}$, $SOHE_{coulomb}$ et $SOHE_R$ estimées par trois méthodes indépendantes. A l'instant de calcul t les capteurs 6, 7 et 8 de la figure 1 déterminent une température T de la batterie 4, une tension U aux bornes de la batterie 4 et une intensité i traversant la batterie 4. Ces valeurs sont regroupées dans la case 10 représentant les mesures effectuées à l'instant t. A ce même instant t, sont disponibles dans des cases mémoire une première valeur « âge » dans une case mémoire 12 et une valeur $U_0$ dans une case mémoire 11. La valeur « âge » est issue d'un calcul d'état de vieillissement effectué précédemment (calculée à partir du modèle $SOHE_{model}$), la valeur $U_0$ est une valeur de tension à vide de la batterie 4 enregistrée à l'instant $t_{i0}$ précédant l'instant t, pendant lequel la batterie ne recevait ni ne délivrait de courant. Selon des variantes de réalisation, la valeur $U_0$ peut être réévaluée par diverses méthodes en fonction des autres mesures T, U, i effectuées à intervalles périodiques. Le BMS 5 comprend un calculateur de SOC 13 qui suivant les méthodes connues, estime une valeur SOC(t) correspondant à un état de charge de la batterie 4 à l'instant t. Typiquement, cette valeur SOC peut être calculée en fonction de l'historique de tension U, de l'historique d'intensité de courant i et, suivant les méthodes utilisées, en fonction des dernières valeurs de tension à vide $U_0$ disponibles.

Le BMS 5 comprend un estimateur d'état de vieillissement de type empirique 14, qui utilise les valeurs d'état de charge SOC calculées par le calculateur 13 et les températures T mesurées par le capteur 6. L'estimateur 14 délivre généralement une valeur $SOHE_{model}$ de T qui fait intervenir des combinaisons linéaires de coefficients tabulés en fonction d'un couple d'état SOC,T, certains coefficients étant associés à un état de repos de la batterie et pondérés alors par un temps de séjour de la batterie dans cet état, et d'autres coefficients étant pondérés par les variations d'énergie subies par la batterie lorsqu'elle se trouvait dans l'état correspondant au couple SOC,T.

Le BMS 5 comprend également un estimateur par résistance interne 16 qui effectue une estimation d'une résistance interne apparente de la batterie 4 et en déduit ensuite, à l'aide d'une cartographie 18, une valeur $SOHE_R$ d'état de vieillissement de la batterie 4.

L'estimation de la résistance interne R de la batterie 4 peut notamment être effectuée en mesurant pendant une phase de charge/décharge de la batterie une variation de courant débité $\Delta_i$ associée à une variation de tension débitée $\Delta U$.

L'estimateur 15 de l'état de vieillissement de la batterie 4 par comptage coulombique effectue une estimation de la capacité de charge $Q_{max}$ de la batterie à l'instant t. L'estimateur 15 peut utiliser à cet effet un écart $\Delta SOC$ d'état de charge de la batterie qui lui est transmis par le calculateur 13 de SOC. Le choix de l'instant initial à partir duquel est calculé l'écart de SOC jusqu'à l'instant t ainsi que la mémorisation de la valeur de SOC correspondant à cet état initial peut être faite soit au niveau de l'estimateur 13 soit au niveau de l'estimateur 15.

L'estimateur coulombique 15 reçoit également des informations concernant les intensités de courant i(t) enregistrées au cours du temps, par exemple reçoit dans l'intégrateur 21 une valeur intégrale des intensités de courant i(t) mesurées au cours du temps jusqu'à l'instant t. A partir de ces valeurs, l'estimateur coulombique calcule la capacité de charge maximale $Q_{max}$ de t et éventuellement après avoir divisé cette charge maximale par une valeur initiale de charge maximale à l'état neuf de la batterie, utilise cette valeur pour lire dans une cartographie 17 une valeur d'état de vieillissement $SOHE_{coulomb}$. En parallèle au calcul des valeurs d'état de vieillissement $SOHE_{model}$, $SOHE_{coulomb}$, $SOHE_R$, le BMS 5 sélectionne trois coefficients barycentriques $\alpha_1$, $\alpha_2$, $\alpha_3$ à l'aide d'un sélectionneur 19. Les valeurs $\alpha_1$, $\alpha_2$, $\alpha_3$ peuvent être des fonctions de la valeur « âge » enregistrée dans la mémoire 12, ou peuvent être lues dans des cartographies qui sont fonction de cette valeur « âge ». Le BMS 5 calcule une valeur barycentrique d'état de vieillissement de la batterie 4 en pondérant les trois valeurs $SOHE_{model}$, $SOHE_{coulomb}$ et $SOHE_R$ par les trois coefficients barycentriques $\alpha_1$, $\alpha_2$, $\alpha_3$ à une étape de pondération 20.

Une fois effectuée l'estimation de cet état de vieillissement barycentrique, le BMS 5 peut utiliser la valeur ainsi trouvée pour déterminer par exemple une tension $V_{charge\_max}$ maximale de fin de rechargement de la batterie. Le BMS peut utiliser cette valeur $V_{charge\_max}$ pour limiter la tension maximale de rechargement lors de l'étape de rechargement suivante de la batterie, si une nouvelle valeur de charge maximale n'est pas calculée entretemps. Le BMS peut aussi utiliser la valeur $SOHE_{bary}$ pour calculer de manière précise la quantité d'énergie disponible dans la batterie à la fin du rechargement, et en déduire l'autonomie kilométrique qui est affichée à l'intention du conducteur du véhicule. La dernière valeur $SOHE_{bary}$ peut en outre être utilisée lors du calcul du SOC, jusqu'à ce qu'une nouvelle valeur de $SOHE_{bary}$ soit disponible.

A une étape 22, on actualise la valeur « âge » servant à déterminer le coefficient barycentrique $\alpha_1$, $\alpha_2$, $\alpha_3$, en enregistrant dans la mémoire 12 la nouvelle valeur $SOHE_{model}(t)$ calculée. On incrémente ensuite le compteur de temps t à une étape 23 et on procède à une nouvelle série de mesures $T(t)$, $(U(t)$, $i(t))$, à l'aide des capteurs de température, de tension, et d'intensité de courant.

L'invention propose de calculer l'état de vieillissement, SOHE, de la batterie, en combinant plusieurs méthodes de calcul. Typiquement, la valeur caractérisant l'état de vieillissement est égale à 1 (ou égale à 100%) quand la batterie est neuve, et diminue ensuite. La valeur SOHE calculée selon l'invention est un barycentre de plusieurs estimations obtenues indépendamment les unes des autres par plusieurs méthodes. Le poids le plus important est attribué à la méthode pour laquelle on pense que l'erreur sera a priori moindre à une étape donnée de la vie de la batterie. Pour ce faire, le poids attribué aux différentes méthodes est calculé en fonction de la dernière évaluation effectuée de l'état de vieillissement de la batterie. Par exemple, quand la valeur $SOHE_{model}$ passe en dessous d'un premier seuil, on commence à faire varier linéairement en fonction du $SOHE_{model}$, les poids des différentes méthodes. Le BMS 5 amène par exemple de 1 à zéro le coefficient associé à une méthode utilisée en début de vie de la batterie, et fait passer simultanément de zéro à 1 le coefficient d'une méthode qui devient préférentielle en seconde partie de vie de la batterie. On peut appliquer une nouvelle fois la démarche lorsque le $SOHE_{model}$ passe en deçà d'un second seuil, de manière à privilégier une troisième méthode de calcul du SOHE en fin de vie de la batterie. Selon une autre variante de réalisation, on peut appliquer une première méthode de calcul en début de vie de la batterie, puis faire évoluer les coefficients barycentriques pour calculer, en milieu et/ou en fin de vie, une valeur qui est une moyenne pondérée -à coefficients constants- entre les résultats de deux autres méthodes de calcul. D'autres combinaisons sont possibles, et les coefficients barycentriques ne passent pas nécessairement par les valeurs zéro ou 1.

Nous allons donner les grandes lignes de calcul de trois méthodes d'estimation élémentaires préférentielles du SOHE. Un BMS selon l'invention est configuré de préférence de manière à utiliser une combinaison barycentrique d'au moins deux de ces méthodes élémentaires. Le barycentre est calculé de préférence en mettant un poids plus important sur une méthode de type "empirique" quand la batterie est neuve, et augmenté par la suite le poids d'au moins une seconde méthode soit de type "comptage coulombique", soit de type estimation de la "résistance interne" de la batterie.

La valeur de SOHE peut être calculée soit de manière globale pour toute une batterie, soit, notamment si on dispose de capteurs de tension pour chaque cellule, et d'un estimateur de température permettant d'évaluer une température de chaque cellule de la batterie, en calculant d'abord un SOHE pour chaque cellule, et en prenant comme valeur de SOHE de la batterie à un instant donné, la valeur minimale de SOHE calculée pour toutes les cellules à cet instant.

Estimation de l'état de vieillissement d'une cellule de batterie en fonction de la résistance interne.

Le BMS calcule le SOHE à partir du calcul de la résistance apparente de la cellule sur une forte variation d'intensité de courant (charge ou décharge). Le principe général est le suivant : on compare la variation du courant pendant une période de temps donnée avec la variation de la tension aux bornes de la cellule. Le ratio de la variation de tension par la variation d'intensité de courant correspond alors à la «résistance apparente» de la cellule. Si cette résistance apparente est déterminée sur une plage de fréquence spécifique, on parle d'impédance de cellule. Au moins deux techniques de mise en oeuvre sont possibles.

On compare cette résistance apparente $RESISTANCE_{apparente}^{cellule}$ à la valeur de la résistance interne

$RESISTANCE\;_{NEUVE}^{cellule}$ qu'aurait eu cette cellule à l'état neuf dans les mêmes conditions de charge ou de décharge. On calcule alors un paramètre appelé par exemple SOHP, qui est un ratio caractérisant l'augmentation de la résistance interne de la cellule.

-

$$SOHP = \frac{RESISTANCE_{NEUVE}^{cellule}}{RESISTANCE_{apparente}^{cellule}}$$   (équation 1)

Enfin, une cartographie préenregistrée permet de lire une valeur $SOHE_R$ en fonction de la valeur SOHP ainsi estimée.

Cette approche a l'avantage d'être simple à mettre en oeuvre.

La résistance «apparente» calculée sur la cellule est une valeur qui peut également être utile pour le calcul de l'intensité maximale de courant autorisée, afin de ne pas solliciter la cellule au-delà de sa puissance maximale autorisée (en décharge, en charge sur secteur et en freinage récupératif).

On peut reprocher à la valeur $RESISTANCE\;_{NEUVE}^{cellule}$ d'être la résistance d'une cellule neuve mesurée dans des conditions spécifiques clairement identifiées (par exemple pic de courant normalisé), mais, qui ne sont justement pas celles dans lesquelles la résistance apparente est mesurée (puisque le profil de courant est piloté par le conducteur). Le SOHP calculé diffère donc du SOHP ayant servi à établir la cartographie.

En outre, certaines cellules peuvent avoir une résistance apparente interne qui diminue en début de vie (ce qui peut sembler surprenant). Le lien entre le SOHP et SOHE n'est alors pas bijectif, en particulier en début de vie. Cela rend l'estimation du vieillissement de la batterie à partir de l'estimation de la résistance interne de la batterie très aléatoire, en particulier en début de vie.

Une méthode d'estimation en fonction de la résistance interne de la cellule est d'autant plus précise que les variations d'intensité de courant traversant la batterie sont importantes. La capacité du BMS à avoir une estimation précise du SOC dépendra donc du profil d'utilisation du conducteur du véhicule.

Il est possible de calculer l'impédance d'une cellule par une excitation sur une bande de fréquence spécifique.

La bande de fréquence spécifique peut éventuellement se limiter à une seule fréquence. Cette estimation nécessite l'application d'une excitation en courant (ou en tension) sur cette bande de fréquence spécifique; excitation qui peut provenir du système de charge, ou d'autres composants d'électronique de puissance du circuit haute tension (tels qu'un DC/DC).

Ce dernier type de caractérisation de la cellule est répétable car l'excitation en courant dans la bande de fréquence d'intérêt peut être construite de manière à être toujours la même. Cela rend la comparaison de l'impédance mesurée à la valeur qu'aurait eut une cellule neuve dans les mêmes conditions plus pertinente pour le calcul du SOHP.

Cependant, cette caractérisation nécessite une architecture et un système de contrôle spécifique pour le système d'électronique de puissance, afin de permettre au système d'appliquer sur les batteries une excitation répétable sur la bande de fréquence bien définie.

L'estimation de l'état de vieillissement $SOHE_R$ d'une cellule de batterie en fonction de la résistance interne est considérée ici comme une estimation en boucle fermée, en ce sens que les valeurs calculées permettent de déceler un vieillissement prématuré de la cellule si celle-ci ne se comporte pas comme une cellule de référence ayant servi à étalonner la méthode de calcul.

Estimation de l'état de vieillissement d'une cellule de batterie par comptage coulombique.

Le principe général est le suivant : on compare :

-   l'évolution au cours d'un cyclage de l'état de charge de la cellule : $\Delta SOC = SOC_{Fin} - SOC_{init}$ où $SOC_{Fin}$ est l'état de charge en fin de cycle et $SOC_{init}$ est l'état de charge en début de cycle,
-   la charge électrique totale qui a été débitée par la cellule pendant le cycle : $Q = \int i.dt$ où I est le courant traversant la cellule.

A partir de la charge électrique débitée, et de la variation de SOC, on recalcule la charge maximale $Q_{max}$ que la cellule serait apte à débiter si on la rechargeait à ce moment à sa capacité maximale :

$Q_{max}$ est aussi désigné par "capacité totale de la cellule"

$$Q_{max} = \frac{\int i.dt}{\Delta SOC}$$

Le rapport SOHQ de cette capacité maximale à la capacité maximale à neuf de la cellule, soit $SOHQ = \dfrac{Q_{max}}{Q_{max}^{CelluleNeuve}}$ , permet, à l'aide d'une cartographie, de remonter à une valeur SOHE$_{coulomb}$ caractérisant l'état de vieillissement de la cellule.

Cette approche est assez simple à mettre en oeuvre. Cependant, le calcul n'est pertinent que si le SOC est calculé à partir de la tension aux bornes de la cellule. Le calcul est peut être faussé par une erreur d'estimation du SOC (à cause de la polarisation des cellules).

Le calcul peut être également entaché d'erreur par une mauvaise mesure du courant (en particulier à cause d'un offset de courant).

Pour obtenir une estimation précise du SOHE, les valeurs doivent être enregistrées sur un cycle correspondant à une variation de SOC de forte amplitude. La capacité du BMS à avoir une estimation précise du SOC dépendra donc des habitudes de roulage et de rechargement de la batterie du conducteur du véhicule.

Dans cette méthode de calcul, il est nécessaire de ré-estimer les valeurs de SOC en début et en fin de cycle à partir de l'information «Tension de cellule ». Une hypothèse importante à prendre en compte est donc est-ce que la courbe reliant la tension et l'état de charge SOC est connue, et qu'elle ne dépend que de manière secondaire du vieillissement. Cette méthode peut causer une fluctuation importante de l'état de vieillissement estimé par le BMS, car ce type d'estimation est fortement dépendant du profil de cyclage (profil de courant, température cellule).

L'estimation de l'état de vieillissement d'une cellule de batterie par comptage coulombique est également considérée ici comme une estimation en boucle fermée. Les valeurs calculées permettent de déceler un vieillissement prématuré de la cellule si la dégradation de la cellule est liée essentiellement à la perte de matériau actif.

Estimation de l'état de vieillissement d'une cellule de batterie à l'aide d'un modèle embarqué de vieillissement.

Le principe général est le suivant : le modèle de vieillissement de la cellule permet de calculer la rétention de capacité de la cellule à partir du temps passé par celle-ci à chaque niveau de SOC et à chaque niveau de température. Le modèle est un modèle en boucle ouverte. Ce calcul ne permet pas de déceler si le vieillissement de la cellule correspond à celui de la cellule de référence ayant servi à calibrer le modèle. En revanche, cette méthode de calcul ne nécessite pas de profil de cyclage particulier de la batterie.

Le modèle propose d'estimer une valeur SOHE$_{model}$ d'état de vieillissement de la cellule suivant une formule du type :

$$SOHE_{model} = 1 - \sum_{T,BSOC}\left\{\alpha(SOC,T)^{\frac{1}{n}}\cdot \delta t(SOC,T)\right\}^{n} - \sum_{T,BSOC}\left\{\beta(SOC,T)^{\frac{1}{m}}\cdot \delta E(SOC,T)\right\}^{m}$$

où

$\alpha$ (SOC, T) est un coefficient cartographie de dégradation calendaire, associé à une plage d'états de charge [SOC-$\Delta_{soc}$, SOC+$\Delta_{SOC}$] et à une plage de température [T-$\Delta_T$, T+$\Delta_T$] données, par exemple centrées respectivement sur une valeur SOC et une valeur T donnée.

$\delta T$ est le temps total passé par la cellule dans la plage d'états de charge [SOC-$\Delta_{soc}$, SOC+$\Delta_{SOC}$] et dans la plage de températures [T-$\Delta_T$, T+$\Delta_T$] considérée.

La somme $\sum_{T,BSOC}$ porte sur l'ensemble des intervalles [SOC-$\Delta_{SOC}$, SOC+$\Delta_{SOC}$] et [T-$\Delta_T$, T+$\Delta_T$] envisageables lors du fonctionnement de la cellule.

$\beta$ est un coefficient cartographie de dégradation par cyclage, associé à une plage d'états de charge [SOC-$\Delta_{soc}$, SOC+$\Delta_{SOC}$] et à une plage de température [T-$\Delta_T$, T+$\Delta_T$] données.

$\delta E$ est l'énergie totale déchargée en kWh pendant le cyclage de la batterie, chaque fois que la batterie se trouve dans une plage d'états de charge [SOC-$\Delta_{soc}$, SOC+$\Delta_{SOC}$] et dans une plage de température [T-$\Delta_T$, T+$\Delta_T$] données.

m et n sont des exposants, entiers ou non, compris de préférence entre 0,5 et 2.

Selon une variante de réalisation, on peut cartographier directement les coefficients $\alpha(SOC,T)^{\frac{1}{n}}$ et $\beta(SOC,T)^{\frac{1}{m}}$

Typiquement, on calcule en permanence l'intégrale $\int U.idt$ depuis le dernier instant où soit le SOC, soit la température T ont franchi une des bornes des intervalles définis pour cartographier $\alpha$ et $\beta$. Quand on franchit à nouveau une des bornes, on ajoute la valeur de l'intégrale à une mémoire associée au couple d'intervalles [SOC-Δsoc, SOC+$\Delta_{SOC}$], [T-$\Delta_T$, T+$\Delta_T$] que l'on vient de quitter, et on recommence à calculer ∫*U.idt* en vu de l'ajouter à une autre case mémoire correspondant au nouveau couple d'intervalles correspondant à l'état actuel de la cellule.

Selon un mode de réalisation particulier, le paramètre β peut également dépendre du niveau de courant traversant la cellule.

Cette méthode de calcul par modèle empirique évite les fluctuations importantes du SOHE estimé.

Le modèle étant en boucle ouverte, il nécessite la réalisation de nombreux tests cellule de caractérisation du vieillissement pour pouvoir calibrer le modèle. La calibration est d'autant plus pertinente que la batterie présente des caractéristiques et des évolutions de caractéristiques proches de la cellule de référence ayant servi à calibrer le modèle, et a priori le plus pertinent en début de vie de la cellule.

Si la batterie est soumise à une haute température, pendant que le BMS est éteint, le calcul du vieillissement ne prendra pas en compte de phénomène.

Choix des coefficients de pondération

L'invention permet de profiter des avantages de chacune de ces méthodes à différents stades du vieillissement de la batterie :

- en début de vie, le calcul par modèle embarqué de vieillissement est non seulement précis, mais, il permet d'éviter des fluctuations importantes de l'état de vieillissement SOHE estimé par le BMS.
- en fin de vie, il est intéressant d'estimer par une boucle fermée (à partir de la résistance interne et/ou à partir du comptage Coulombique) afin de détecter toute dégradation de la batterie (que le modèle n'aurait pas prévu). L'invention propose donc de calculer un estimateur d'état de vieillissement $SOHE_{bary}$ de la batterie calculé de la manière suivante :

$$SOHE_{bary} = \alpha_1 \cdot SOHE_{Model} + \alpha_2 \cdot SOHE_{Coulomb} + \alpha_3 \cdot SOHE_R,$$

avec $\alpha_1$, $\alpha_2$ et $\alpha_3$ des coefficients barycentriques associés au calcul de l'état de vieillissement, vérifiant

$$\alpha_1 + \alpha_2 + \alpha_3 = 1$$

Au lieu de faire varier les coefficients de pondération en fonction du temps, l'invention propose de faire varier les coefficients $\alpha_1$, $\alpha_2$ et $\alpha_3$ en fonction du niveau de vieillissement $SOHE_{bary}$ estimé par le BMS à un instant précédent.

$SOHE_{model}$, $SOHE_{Coulomb}$ et $SOHE_R$ peuvent être calculées par les méthodes précédemment décrites appliquées directement à la batterie dans son ensemble, en raisonnant sur les tensions aux bornes de la batterie et sur le SOC global de la batterie. $SOHE_{model}$, $SOHE_{Coulomb}$ et $SOHE_R$ peuvent être respectivement calculées comme la valeur minimale sur l'ensemble des cellules de la batterie, parmi les valeurs $SOHE_{model}$, $SOHE_{coulomb}$ et $SOHE_R$ calculées à un instant donné pour chaque cellule de batterie.

Comme mentionné précédemment, l'invention propose de choisir les coefficients $\alpha_1$, $\alpha_2$ et $\alpha_3$ de manière optimisée en fonction de l'état de vieillissement estimé de la batterie.

Selon un mode de réalisation particulier de l'invention, les coefficients $\alpha_1$, $\alpha_2$ et $\alpha_3$ peuvent également dépendre du profil d'utilisation de la batterie et/ou du véhicule sur lequel est montée la batterie. Par exemple, une fois que le $SOHE_{bary}$ passe en deçà d'un premier seuil, on peut diminuer le poids $\alpha_1$ associé à la méthode de calcul $SOHE_{model}$ et augmenter les poids $\alpha_2$ et $\alpha_3$. On peut, dans cette seconde partie de la vie de la batterie, choisir $\alpha_2 < \alpha_3$ (par exemple $\alpha_2=0$ et $\alpha_3=1$) si le ou les derniers cycles de décharge constatés ont une amplitude supérieure à un seuil de décharge (par exemple une amplitude de SOC supérieure à 0,7, et de préférence supérieure à 0,8), et choisir $\alpha_2 > \alpha_3$ (par exemple $\alpha_2=1$ et $\alpha_3=0$) dans le cas contraire.

Selon un mode de réalisation qui peut se combiner au précédent, on peut imposer que le $SOHE_{bary}$ soit systématiquement inférieur ou égal au $SOHE_{model}$ calculé par un modèle empirique, en le limitant par la formule suivante :

$$SOHE_{bary} = Min[(\alpha_1 \cdot SOHE_{Model} + \alpha_2 \cdot SOHE_{Coulomb} + \alpha_3 \cdot SOHE_{DCR}), SOHE_{Model}],$$

On donne dans la suite quelques exemples de profil de variation des coefficients barycentriques.

On souhaite par exemple utiliser de manière prépondérante $SOHE_{model}$ jusqu'à ce que la valeur $SOHE_{bary}$ atteigne une valeur $SOHE_{seuil\_1}$, puis utiliser de manière prépondérante $SOHE_{coulomb}$,

- en début de vie, tant que $SOHE_{bary} > SOHE_{seuil\_1}$, on prend $\alpha_1=1$.

Quand $SOHE_{bary} = SOHE_{seuil\_1}$ puis $SOHE_{bary} < SOHE_{seuil\_1}$, on diminue $\alpha_1$ linéairement (par rapport à $SOHE_{bary}$) de 1 à zéro. Par exemple, on peut faire diminuer $\alpha_1$ linéairement de 1 à zéro sur la plage $SOHE_{bary}$ comprise entre 0.9 et 0.8.

Selon une autre variante de réalisation, la variation linéaire de $\alpha_1$ peut se faire par rapport à $SOHE_{model}$ lui-même, voire même par rapport au kilométrage parcouru par le véhicule sur lequel est montée la batterie,

- pour $SOHE_{model} <80\%$, on prend $\alpha_1=0$.

On peut compenser la diminution de $\alpha_1$ en augmentant linéairement un seul des autres coefficients barycentriques (par exemple $\alpha_2$ pour donner ensuite la prépondérance au calcul coulombique) ou en augmentant linéairement simultanément plusieurs autres coefficients barycentriques.

Il est connu par l'homme de l'art que l'estimation du SOHE à partir de la résistance interne de la batterie est de manière générale moins précise que l'estimation du SOHE par comptage Coulombique, sous réserve que ce comptage Coulombique soit réalisé sur une décharge profonde de la batterie.

Ainsi, tant que le conducteur d'un véhicule alimenté par une batterie ne fait pas de décharge profonde de la batterie, le meilleur moyen d'estimer l'état de vieillissement de la batterie en boucle fermée, consiste à utiliser l'approche basée sur la résistance interne de la batterie.

Selon un mode de réalisation préférentiel, si le conducteur du véhicule n'a utilisé, avant le franchissement de $SOHE_{seuil\_1}$, sa batterie que sur des plages de SOC limitée (par exemple, SOC reste systématiquement supérieur ou égal à 0,7), alors, on choisit de compenser la diminution de $\alpha_1$ par une augmentation de $\alpha_2$, c'est-à-dire que l'on impose $\alpha_2=1-\alpha_1$, et $\alpha_3=0$ jusqu'à ce que ce soit $\alpha_2$ qui devienne égal à 1.

En revanche, si le conducteur du véhicule pendant un nombre minimum de cycles, impose des variations de SOC supérieures à un seuil, par exemple supérieures à une amplitude de SOC de 0,4, alors, on choisit de compenser la diminution de $\alpha_1$ par une augmentation de $\alpha_3$, c'est-à-dire que l'on impose $\alpha_3=1-\alpha_1$, et $\alpha_2=0$ jusqu'à ce que ce soit $\alpha_3$ qui devienne égal à 1.

On peut également, alors que l'on est dans le cas de figure où $\alpha_2=1$, après avoir détecté un nombre minimum de cycles avec des variations de SOC supérieures à un seuil, par exemple supérieures à une amplitude de SOC de 0,4, diminuer linéairement $\alpha_2$ et compenser la diminution de $\alpha_2$ par une augmentation de $\alpha_3$, c'est-à-dire que l'on impose $\alpha_3=1-\alpha_2$, et $\alpha_1=0$ jusqu'à ce que ce soit $\alpha_3$ qui devienne égal à 1.

D'autres cas de figure sont bien sûr possibles, par exemple en compensant une diminution linéaire de $\alpha_1$ en augmentant simultanément $\alpha_2$ et $\alpha_3$, par exemple $\alpha_2=\alpha_3$ et $\alpha_2=0,5-0,5.\alpha_1$.

On sait que plus la tension de fin de charge de la batterie est élevée, plus la batterie se dégrade vite lors des cyclages. Au bout de quelques mois ou années, l'état de vieillissement de la batterie se dégrade plus rapidement que si la batterie avait subi des cyclages sur une plage de SOC réduite. Il y a donc un compromis à gérer par la gestion de la tension de fin de charge entre l'énergie dont on veut disposer en fin de recharge à court terme, et la durabilité de la batterie.

Selon une variante de l'invention, afin d'améliorer la durée de vie de la batterie, le BMS impose, au début du cycle de vie de la batterie, une tension maximale en fin de recharge qui est inférieure à la tension maximale acceptable en fin de recharge. Le BMS augmente ensuite cette tension maximale au cours du cycle de vie de la batterie, la variation de la tension maximale suivant une courbe prédéfinie en fonction des valeurs barycentriques SOHE calculées. La progression peut par exemple être affine croissante, entre la mise en service de la batterie, et le moment où la tension maximale de fin de charge imposée par le BMS devient égale à la tension maximale de fin de charge préconisée par le constructeur de la batterie, ou devient égale à une tension maximale arbitraire fixée d'avance. A partir de ce moment, le BMS peut ensuite imposer toujours la même tension maximale de fin de charge. La courbe de tension maximale de fin de charge présente alors un plateau pour les valeurs de SOHE inférieures à un seuil (dans le cas où les valeurs hautes de SOHE correspondent à un état neuf de la batterie). D'autres formes de courbe sont bien sûr possibles, dans lesquelles la vitesse d'accroissement de la tension maximale en fin de charge (exprimée par exemple par rapport à $-SOHE_{bary}$) diminue avec l'augmentation de l'âge de la batterie.

L'invention ne se limite pas aux exemples de réalisation décrits, et peut se décliner en de nombreuses variantes. On peut par exemple effectuer le raisonnement en utilisant une valeur caractéristique de l'état de vieillissement de la batterie qui est croissante au cours du temps, par exemple en prenant le complément à 1 (ou le complément à 100%) des valeurs SOHE décrites plus haut. Les valeurs de SOC, SOHE et SOHP peuvent être comptées entre zéro et 1, ou multipliées à une valeur arbitraire constante, par exemple 100%. L'estimation des SOHE selon les différentes méthodes de calcul prises en compte dans le calcul barycentrique peut être calculée de manière globale pour toute la batterie, ou de préférence pour chaque cellule pour tenir compte au besoin du vieillissement prématuré d'une ou plusieurs cellules en particulier. On peut faire varier les coefficients barycentriques en fonction des valeurs prises par une des estimations élémentaires de SOHE autre que l'estimation $SOHE_{model}$ par modèle embarqué, par exemple en fonction d'une valeur $SOHE_{coulomb}$ obtenue par méthode de type comptage coulombique, ou d'une valeur $SOHE_R$ calculée par une méthode faisant intervenir un calcul de l'évolution d'une impédance ou d'une résistance interne de l'accumulateur. Selon encore un autre mode de réalisation, on peut faire varier les coefficients barycentriques en fonction de la valeur barycentrique elle même calculée à un instant précédent. Il est intéressant de faire varier ces coefficients en fonction $SOHE_{model}$, qui présente moins de fluctuations aléatoires que les autres méthodes d'estimation. De manière préférentielle, le franchissement d'un seuil de SOHE dans un sens (par exemple le passage en dessous d'un SOHE seuil), provoque un changement de coefficients barycentriques, mais ne provoque pas de changement de coefficients en sens inverse en cas de fluctuations ultérieures autour de ce seuil.

L'invention permet d'améliorer la précision et de diminuer les dispersions d'estimation de valeurs d'état de vieillissement d'une batterie d'accumulateurs. Cette cohérence dans l'estimation de l'état de vieillissement de la batterie permet ensuite une gestion fiable et cohérente des tensions de fin de charge de la batterie, afin d'améliorer la durée de vie de la batterie, tout en assurant au conducteur du véhicule une autonomie kilométrique à la fin de chaque recharge qui évolue de manière régulière et modérée.

**Revendications**

1. Procédé de gestion d'un accumulateur électrochimique (4) ou d'une batterie d'accumulateurs, dans lequel on détermine une valeur estimée ($SOHE_{bary}(t)$) d'un état de vieillissement de l'accumulateur (4) cette valeur estimée étant utilisée pour contrôler l'alimentation en électricité d'un véhicule par l'accumulateur ou la batterie, à partir notamment de l'historique des valeurs de tension ($U(t)$) aux bornes de l'accumulateur (4), de l'historique de l'intensité ($i(t)$) de courant traversant l'accumulateur, et de l'historique de température ($T(t)$) de l'accumulateur, dans lequel la valeur estimée ($SOHE_{bary}(t)$) est une valeur barycentrique d'état de vieillissement calculée comme un barycentre d'au moins deux valeurs indicatives de l'état de vieillissement de l'accumulateur, soit une première valeur indicative ($SOHE_{model}(t)$) de l'état de vieillissement de l'accumulateur calculée par une première méthode et une seconde valeur indicative ($SOHE_R(t)$) de l'état de vieillissement de l'accumulateur (4) calculée par une seconde méthode différente de la première méthode, le procédé étant **caractérisé en ce que**, à partir d'un état initial de mise en service de l'accumulateur (4), on fait varier linéairement au moins une fois les coefficients barycentriques ($\alpha_1$, $\alpha_2$) permettant de calculer la prochaine valeur barycentrique d'état de vieillissement de l'accumulateur, quand une précédente valeur du SOHE calculée selon la première méthode ($SOHE_{model}(t)$) d'état de vieillissement de l'accumulateur a franchi un premier seuil, de manière à attribuer le poids le plus important à la méthode pour laquelle l'erreur est la plus faible.

2. Procédé de gestion selon la revendication 1, dans lequel la première valeur indicative ($SOHE_{model}(t)$) est calculée à partir d'une première somme de premiers coefficients fonctions de températures et états de charges caractérisant des états successifs de l'accumulateur, premiers coefficients multipliés chacun par le temps passé dans chaque état, et d'une seconde somme de seconds coefficients fonctions de températures et états de charges caractérisant des états successifs de l'accumulateur, seconds coefficients multipliés chacun par l'énergie déchargée par la batterie dans cet état.

3. Procédé de gestion selon la revendication 2, dans lequel le coefficient barycentrique ($\alpha_1$) associé à la valeur calculée par la première méthode ($SOHE_{model}(t)$) est strictement supérieur à 0,5 lors de la mise en service de la batterie et diminue ensuite, et dans lequel le coefficient barycentrique ($\alpha_2$, $\alpha_3$) associé à la valeur calculée par la seconde méthode ($SOHE_{coulomb}(t)$, $SOHE_R(t)$) est strictement inférieur à 0,5 et augmente ensuite au cours du temps.

4. Procédé selon la revendication 3, dans lequel le coefficient barycentrique ($\alpha_1$) associé à la première valeur indicative de l'état de vieillissement ($SOHE_{model}(t)$) reste constant jusqu'à ce que la valeur barycentrique ($SOHE_{bary}(t)$) franchisse un premier seuil, puis varie de manière sensiblement affine en fonction de la valeur barycentrique ($SOHE_{bary}(t)$) jusqu'à ce que la valeur barycentrique ($SOHE_{bary}(t)$) franchisse un second seuil.

5. Procédé selon l'une quelconque des revendications 2 à 4, dans lequel la valeur barycentrique ($SOHE_{bary}(t)$) est plus proche de la première valeur indicative de l'état de vieillissement ($SOHE_{model}(t)$) jusqu'au franchissement d'un premier seuil par la valeur barycentrique ($SOHE_{bary}(t)$), puis la valeur barycentrique ($SOHE_{bary}(t)$) devient progressivement la plus proche d'une seconde valeur indicative de l'état de vieillissement ($SOHE_{coulomb}(t)$), jusqu'au franchissement d'un troisième seuil par la valeur barycentrique ($SOHE_{bary}(t)$), puis la valeur barycentrique devient progressivement la plus proche d'une troisième valeur indicative de l'état de vieillissement ($SOHE_R(t)$) jusqu'au franchissement d'un quatrième seuil par la valeur barycentrique ($SOHE_{bary}(t)$).

**6.** Procédé selon la revendication 5, dans lequel la seconde valeur indicative de l'état de vieillissement ($SOHE_{coulomb}(t)$) est calculée par une méthode de type comptage coulombique, et la troisième valeur indicative de l'état de vieillissement ($SOHE_R(t)$) est calculée par une méthode faisant intervenir un calcul de l'évolution d'une impédance ou d'une résistance interne de l'accumulateur (4).

**7.** Procédé de gestion selon l'une quelconque des revendications précédentes, dans lequel, au cours des étapes de rechargement de l'accumulateur (4), on impose une tension de fin de charge qui est calculée en fonction de la valeur barycentrique ($SOHE_{bary}(t)$), cette tension de fin de charge étant augmentée progressivement au cours de l'utilisation de l'accumulateur (4) sur un véhicule.

**8.** Procédé selon la revendication 7, dans lequel la tension de fin de charge est imposée pour varier de manière affine par rapport à la valeur barycentrique ($SOHE_{bary}(t)$), entre la mise en service de l'accumulateur et une cinquième valeur seuil de la valeur barycentrique, puis est maintenue sensiblement constante pour la suite de l'utilisation de l'accumulateur (4) sur un véhicule.

**9.** Système d'alimentation électrique pour véhicule automobile comprenant au moins un accumulateur électrochimique (4), un capteur de température (6) associé à l'accumulateur (4), un capteur (7) de tension et un capteur (8) d'intensité de courant permettant d'estimer respectivement la tension ($U(t)$) aux bornes de l'accumulateur (4) et l'intensité de courant ($i(t)$) traversant l'accumulateur (4), un calculateur (13) configuré pour estimer, en utilisant notamment les valeurs de tension ($U(t)$ et d'intensité ($i(t)$) un niveau de charge ($SOC(t)$) de l'accumulateur (4) au cours du temps ($t$), le système comprenant une unité de commande électronique (5) configurée pour calculer une valeur barycentrique d'un état de vieillissement de l'accumulateur ($SOHE_{bary}(t)$), comme un barycentre d'au moins une première ($SOHE_{model}(t)$), et une seconde ($SOHE_{coulomb}(t)$, $SOHE_R(t)$) valeurs caractérisant un état de vieillissement de l'accumulateur et calculées par deux méthodes différentes, le système étant **caractérisé en ce que** l'unité de commande est configurée de sorte que les coefficients barycentriques ($\alpha_1$, $\alpha_2$, $\alpha_3$) utilisés pour calculer la valeur barycentrique ($SOHE_{bary}(t)$), à un instant donné dépendent linéairement de la valeur prise par le SOHE calculé selon la première méthode ($SOHE_{model}(t)$)lors de l'évaluation de celle-ci à un instant précédent, de manière à attribuer le poids le plus important à la méthode pour laquelle l'erreur est la plus faible.

**10.** Système d'alimentation électrique selon la revendication 9, comprenant une unité de gestion de l'accumulateur (5) configurée pour augmenter au cours du cycle de vie de l'accumulateur (4), la tension de fin de charge définissant la tension maximale à laquelle on autorise un système de recharge à amener l'accumulateur, la tension de fin de charge étant imposée en fonction de la valeur barycentrique calculée ($SOHE_{bary}(t)$).

**Patentansprüche**

**1.** Verwaltungsverfahren eines elektrochemischen Akkumulators (4) oder einer Akkumulatorenbatterie, wobei ein geschätzter Wert ($SOHE_{bary}(t)$) eines Alterungszustands des Akkumulators (4) bestimmt wird, wobei dieser geschätzte Wert verwendet wird, um die Versorgung eines Fahrzeugs mit Elektrizität durch den Akkumulator oder die Batterie zu kontrollieren, ausgehend insbesondere vom Status der Spannungswerte ($U(t)$) an den Klemmen des Akkumulators (4), vom Status der den Akkumulator durchquerenden Stromstärke ($i(t)$) und vom Status der Temperatur ($T(t)$) des Akkumulators, wobei der geschätzte Wert ($SOHE_{bary}(t)$) ein baryzentrischer Wert des Alterungszustands ist, berechnet wie ein Baryzentrum von mindestens zwei den Alterungszustand des Akkumulators anzeigenden Werten, d.h. einem ersten den Alterungszustand des Akkumulators anzeigenden Wert ($SOHE_{model}(t)$) berechnet durch eine erste Methode und einem zweiten den Alterungszustand des Akkumulators (4) anzeigenden Wert ($SOHE_R(t)$) berechnet durch eine zweite Methode anders als die erste Methode, wobei das Verfahren **dadurch gekennzeichnet ist, dass** ausgehend von einem Anfangszustand der Inbetriebnahme des Akkumulators (4) die baryzentrischen Koeffizienten ($\alpha_1$, $\alpha_2$) mindestens einmal linear variiert werden, was es ermöglicht, den nächsten baryzentrischen Wert des Alterungszustands des Akkumulators zu berechnen, wenn ein vorhergehender Wert des SOHE berechnet gemäß der ersten Methode ($SOHE_{model}(t)$) des Alterungszustands des Akkumulators eine erste Schwelle überschritten hat, um der Methode das größte Gewicht zu verleihen, bei der der Fehler am geringsten ist.

**2.** Verwaltungsverfahren nach Anspruch 1, wobei der erste anzeigende Wert ($SOHE_{model}(t)$) ausgehend von einer ersten Summe erster temperatur- und ladezustandsabhängiger Koeffizienten, die aufeinanderfolgende Zustände des Akkumulators charakterisieren, erster Koeffizienten, die je mit der in jedem Zustand vergangenen Zeit multipliziert werden, und einer zweiten Summe zweiter temperatur- und ladezustandsabhängiger Koeffizienten berechnet wird, die aufeinanderfolgende Zustände des Akkumulators charakterisieren, zweiter Koeffizienten, die je mit der von der Batterie in diesem Zustand entladenen Energie multipliziert werden.

3. Verwaltungsverfahren nach Anspruch 2, wobei der dem von der ersten Methode (SOHE$_{model}$(t)) berechneten Wert zugeordnete baryzentrische Koeffizient ($\alpha_1$) bei der Inbetriebnahme der Batterie strikt höher als 0,5 ist und anschließend abnimmt, und wobei der dem von der zweiten Methode (SOHE$_{coulomb}$(t)) berechneten Wert zugeordnete baryzentrische Koeffizient ($\alpha_2$, $\alpha_3$) strikt niedriger ist als 0,5 und anschließend im Laufe der Zeit zunimmt.

4. Verfahren nach Anspruch 3, wobei der dem den Alterszustand (SOHE$_{model}$(t)) anzeigenden ersten Wert zugeordnete baryzentrische Koeffizient ($\alpha_1$) konstant bleibt, bis der baryzentrische Wert (SOHE$_{bary}$(t)) eine erste Schwelle überschreitet, dann abhängig vom baryzentrischen Wert (SOHE$_{bary}$(t)) im Wesentlichen affin variiert, bis der baryzentrische Wert (SOHE$_{bary}$(t)) eine zweite Schwelle überschreitet.

5. Verfahren nach einem der Ansprüche 2 bis 4, wobei der baryzentrische Wert (SOHE$_{bary}$(t)) dem ersten den Alterungszustand (SOHE$_{model}$(t)) anzeigenden Wert näher ist bis zum Überschreiten einer ersten Schwelle durch den baryzentrischen Wert (SOHE$_{bary}$(t)), dann der baryzentrische Wert (SOHE$_{bary}$(t)) progressiv einem zweiten den Alterungszustand (SOHE$_{coulomb}$(t)) anzeigenden Wert am nächsten wird, bis zur Überschreitung einer dritten Schwelle durch den baryzentrischen Wert (SOHE$_{bary}$(t)), dann der baryzentrische Wert progressiv einem dritten den Alterungszustand (SOHE$_{coulomb}$(t)) anzeigenden Wert am nächsten wird, bis zum Überschreiten einer vierten Schwelle durch den baryzentrischen Wert (SOHE$_{bary}$(t)) .

6. Verfahren nach Anspruch 5, wobei der zweite den Alterungszustand (SOHE$_{coulomb}$(t)) anzeigende Wert durch eine Methode des Typs Coulomb-Rechnung berechnet wird, und der dritte den Alterungszustand (SOHE$_R$(t)) anzeigende Wert durch eine Methode berechnet wird, die eine Berechnung der Entwicklung einer Impedanz oder eines inneren Widerstands des Akkumulators (4) anwendet.

7. Verwaltungsverfahren nach einem der vorhergehenden Ansprüche, wobei während der Wiederaufladeschritte des Akkumulators (4) eine Ladeschlussspannung vorgegeben wird, die abhängig vom baryzentrischen Wert (SOHE$_{bary}$(t)) berechnet wird, wobei diese Ladeschlussspannung während der Benutzung des Akkumulators (4) auf einem Fahrzeug progressiv erhöht wird.

8. Verfahren nach Anspruch 7, wobei die Ladeschlussspannung vorgegeben wird, um bezüglich des baryzentrischen Werts (SOHE$_{bary}$(t)) zwischen der Inbetriebnahme des Akkumulators und einem fünften Schwellenwert des baryzentrischen Werts affin zu variieren, dann für die Fortsetzung der Benutzung des Akkumulators (4) auf einem Fahrzeug im Wesentlichen konstant gehalten wird.

9. Elektrisches Versorgungssystem für ein Kraftfahrzeug, das mindestens einen elektrochemischen Akkumulator (4), einen dem Akkumulator (4) zugeordneten Temperaturfühler (6), einen Spannungssensor (7) und einen Stromstärkesensor (8), die es ermöglichen, die Spannung (U(t)) an den Klemmen des Akkumulators (4) bzw. die den Akkumulator (4) durchquerende Stromstärke (i(t)) zu schätzen, einen Rechner (13) enthält, der konfiguriert ist, unter Verwendung insbesondere der Spannungs- (U(t) und Stärkewerte (i(t)) einen Ladepegel (SOC(t)) des Akkumulators (4) im Laufe der Zeit (t) zu schätzen, wobei das System eine elektronische Steuereinheit (5) enthält, die konfiguriert ist, einen baryzentrischen Wert eines Alterungszustands des Akkumulators (SOHE$_{bary}$(t)) zu berechnen, wie ein Baryzentrum mindestens eines ersten (SOHE$_{model}$(t)) und eines zweiten (SOHE$_{coulomb}$(t), SOHE$_R$(t)) Werts, die einen Alterungszustand des Akkumulators charakterisieren und von zwei verschiedenen Methoden berechnet werden, wobei das System **dadurch gekennzeichnet ist, dass** die Steuereinheit so konfiguriert ist, dass die baryzentrischen Koeffizienten ($\alpha_1$, $\alpha_2$, $\alpha_3$), die verwendet werden, um den baryzentrischen Wert (SOHE$_{bary}$(t)) zu berechnen, zu einem gegebenen Zeitpunkt linear von dem vom SOHE angenommenen Wert abhängen, der gemäß der ersten Methode (SOHE$_{model}$ (t)) während deren Bewertung zu einem vorhergehenden Zeitpunkt berechnet wird, um der Methode das größte Gewicht zuzuweisen, für die der Fehler der geringste ist.

10. Elektrisches Versorgungssystem nach Anspruch 9, das eine Verwaltungseinheit des Akkumulators (5) enthält, die konfiguriert ist, während des Lebenszyklus des Akkumulators (4) die Ladeschlussspannung zu erhöhen, die die maximale Spannung definiert, auf die ein Wiederaufladesystem berechtigt ist, den Akkumulator zu bringen, wobei die Ladeschlussspannung abhängig vom berechneten baryzentrischen Wert (SOHE$_{bary}$(t)) vorgegeben wird.

**Claims**

1.  Method for managing an electrochemical accumulator (4) or a storage battery, in which an estimated value ($SOHE_{bary}$(t)) of a state of deterioration of the accumulator (4) is determined, this estimated value being used to control the supply of electricity to a vehicle by the accumulator or the battery, in particular from the history of the voltage values (U(t)) across the terminals of the accumulator (4), the history of the intensity (i(t)) of current flowing through the accumulator, and the history of the temperature (T(t)) of the accumulator, in which the estimated value ($SOHE_{bary}$(t)) is a barycentric value of the state of deterioration calculated as a barycentre of at least two values indicative of the state of deterioration of the accumulator, that is to say a first value ($SOHE_{model}$(t)) indicative of the state of deterioration of the accumulator calculated by a first method and a second value ($SOHE_R$(t)) indicative of the state of deterioration of the accumulator (4) calculated by a second method different from the first method, the method being **characterized in that**, from an initial state of commissioning of the accumulator (4), the barycentric coefficients ($\alpha_1$, $\alpha_2$) are varied linearly at least once, making it possible to calculate the next barycentric value of the state of deterioration of the accumulator, when a previous SOHE value of the state of deterioration of the accumulator, calculated according to the first method ($SOHE_{model}$(t)), has passed a first threshold, so as to attribute the greatest weight to the method for which the error is the smallest.

2.  Management method according to Claim 1, in which the first indicative value ($SOHE_{model}$(t)) is calculated from a first sum of first temperature and state of charge coefficients characterizing successive states of the accumulator, the first coefficients each being multiplied by the time spent in each state, and from a second sum of second temperature and state of charge coefficients characterizing successive states of the accumulator, the second coefficients each being multiplied by the energy discharged by the battery in this state.

3.  Management method according to Claim 2, in which the barycentric coefficient ($\alpha_1$) associated with the value calculated by the first method ($SOHE_{model}$(t)) is strictly greater than 0.5 at the time of commissioning of the battery and then decreases, and in which the barycentric coefficient ($\alpha_2$, $\alpha_3$) associated with the value calculated by the second method ($SOHE_{coulomb}$(t), $SOHE_R$(t)) is strictly less than 0.5 and then increases over time.

4.  Method according to Claim 3, in which the barycentric coefficient ($\alpha_1$) associated with the first value indicative of the state of deterioration ($SOHE_{model}$(t)) remains constant until the barycentric value ($SOHE_{bary}$(t)) passes a first threshold, then varies substantially linearly on the basis of the barycentric value ($SOHE_{bary}$(t)) until the barycentric value ($SOHE_{bary}$(t)) passes a second threshold.

5.  Method according to any one of Claims 2 to 4, in which the barycentric value ($SOHE_{bary}$(t)) is closer to the first value indicative of the state of deterioration ($SOHE_{model}$(t)) until a first threshold is passed by the barycentric value ($SOHE_{bary}$(t)), then the barycentric value ($SOHE_{bary}$(t)) gradually becomes the closest to a second value indicative of the state of deterioration ($SOHE_{coulomb}$(t)) until a third threshold is passed by the barycentric value ($SOHE_{bary}$(t)), then the barycentric value gradually becomes the closest to a third value indicative of the state of deterioration ($SOHE_R$(t)) until a fourth threshold is passed by the barycentric value ($SOHE_{bary}$(t)).

6.  Method according to Claim 5, in which the second value indicative of the state of deterioration ($SOHE_{coulomb}$(t)) is calculated by a method of the coulomb counting type, and the third value indicative of the state of deterioration ($SOHE_R$(t)) is calculated by a method involving a calculation of the development of an impedance or of an internal resistance of the accumulator (4) .

7.  Management method according to any one of the preceding claims, in which, during the steps of recharging of the accumulator (4), an end-of-charging voltage is fixed that is calculated on the basis of the barycentric value ($SOHE_{bary}$(t)), this end-of-charging voltage being gradually increased during the use of the accumulator (4) onboard a vehicle.

8.  Method according to Claim 7, in which the end-of-charging voltage is fixed so as to vary linearly with respect to the barycentric value ($SOHE_{bary}$(t)), between the commissioning of the accumulator and a fifth threshold value of the barycentric value, and is then held substantially constant during the subsequent use of the accumulator (4) onboard a vehicle.

9.  Electric power supply system for a motor vehicle comprising at least an electrochemical accumulator (4), a temperature sensor (6) associated with the accumulator (4), a voltage sensor (7) and a current intensity sensor (8) making it possible to estimate, respectively, the voltage (U(t)) across the terminals of the accumulator (4) and the intensity (i(t)) of current flowing through the accumulator (4), a computer (13) configured to estimate a level of charge (SOC(t)) of the accumulator (4) over time (t), in particular by using the voltage (U(t)) and intensity (i(t)) values, the system comprising an electronic control unit (5) configured to calculate a barycentric value of a state of deterioration of the accumulator ($SOHE_{bary}(t)$), such as a barycentre of at least one first ($SOHE_{model}(t)$) and one second ($SOHE_{coulomb}(t)$, $SOHE_R(t)$) value characterizing a state of deterioration of the accumulator and calculated by two different methods, the system being **characterized in that** the control unit is configured so that the barycentric coefficients ($\alpha_1$, $\alpha_2$, $\alpha_3$) used to calculate the barycentric value ($SOHE_{bary}(t)$) at a given time are linearly dependent on the value assumed by the SOHE calculated according to the first method ($SOHE_{model}(t)$) during assessment thereof at a previous time, so as to attribute the greatest weight to the method for which the error is the smallest.

10. Electric power supply system according to Claim 9, comprising an accumulator management unit (5) configured to increase, during the life cycle of the accumulator (4), the end-of-charging voltage defining the maximum voltage to which a recharging system is authorized to bring the accumulator, the end-of-charging voltage being fixed on the basis of the calculated barycentric value ($SOHE_{bary}(t)$).

# FIG.1

# FIG.2

Mémoire

Mesures

Mesures

$\alpha_\iota = \alpha_\iota(Age)$

Model

$\Sigma\delta t\alpha^{\frac{1}{n}}(SOC, T)$

$\Sigma\delta E.\beta^{\frac{1}{m}}(SOC, T)$

$SOHE_{model}(t)$

$SOHE_{coulomb}(t)$

$SOHE_R(t)$

$SOHE_{bary}(t) = \alpha_1 SOHE_{model}(t) + \alpha_2 SOHE_{coulomb}(t) + \alpha_3 SOHE_R(t)$

$V_{charge\ max} = V(Bary(t))$

$Age = SOHE_{model}(t)$

$t = t + 1$

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20070001679 A1
- US 6653817 B
- WO 20121091076 A

**Littérature non-brevet citée dans la description**

- **R. SPOTNITZ.** Simulation of capacity fade in lithium ion batteries. *Journal of Power Sources,* 2003, vol. 113, 72-80
- Enhanced coulomb counting method for estimating state-of-charge and state-of-health of lithium-ion batteries. *Applied Energy,* Septembre 2009, vol. 86 (9), 1506-1511